# DEMANDE DE BREVET EUROPEEN

(11) **EP 4 350 425 A1**
(43) Date de publication de la demande: **10.04.2024**
(21) Numéro de dépôt: 23201539.6
(22) Date de dépôt: 04.10.2023
(51) Int. Cl.: G02F 1/01, B82Y 20/00, G02B 26/08, B81B 3/00

(54) **STRUCTURE OPTO-MÉCANIQUE ET PROCÉDÉS DE FABRICATION ASSOCIÉS**

(30) Priorité: 06.10.2022 FR 2210229
(71) Demandeur: Commissariat à l'énergie atomique et aux énergies alternatives, 75015 Paris (FR)
(72) Inventeur: FURCATTE, Thomas, 38054 Grenoble Cedex 09 (FR); SANSA PERNA, Marc, 38054 Grenoble Cedex 09 (FR); HENTZ, Sébastien, 38054 Grenoble Cedex 09 (FR); KAZAR MENDES, Munique, 38054 Grenoble Cedex 09 (FR)
(74) Mandataire: Cabinet Camus Lebkiri

(57) **Abrégé**

Un aspect de l'invention concerne une structure opto-mécanique (SOM) comportant un substrat (SB) s'étendant selon un plan (P) ; un élément support (ES) agencé sur le substrat (SB ; au moins un élément conducteur (EC) adapté pour créer un champ électrique orienté perpendiculairement au plan (P) du substrat (SB) ; et un résonateur opto-mécanique. De plus, le résonateur opto-mécanique comprend un élément mobile mécaniquement (EM) réalisé dans un matériau piézoélectrique et agencé sur l'élément support (ES), le matériau piézoélectrique étant choisi de sorte que le champ électrique créé par l'élément conducteur (EC) lorsque ce dernier est soumis à un potentiel électrique entraîne un déplacement dudit élément mobile (EM) ; un résonateur optique (RO) couplé à l'élément mobile (EM). Enfin, l'élément conducteur (EC) est situé au-dessus ou au-dessous dudit élément mobile (EM), à une distance non nulle dudit élément mobile (EM), ledit élément conducteur (EC) et ledit élément mobile (EM) ayant une surface en regard l'une de l'autre.

## Description

### DOMAINE TECHNIQUE DE L'INVENTION

Le domaine technique de l'invention est celui des MOEMS (microsystèmes électro-opto-mécaniques).

La présente invention concerne une structure opto-mécanique ainsi qu'un premier procédé de fabrication et un deuxième procédé de fabrication permettant d'obtenir une telle structure.

### ARRIERE-PLAN TECHNOLOGIQUE DE L'INVENTION

Les MOEMS comprennent en général un résonateur mécanique interagissant avec des signaux lumineux, typiquement de la lumière laser cohérente. Ainsi, la lumière laser permet d'actionner ou bien de détecter le mouvement du résonateur mécanique. Cependant, il est également possible d'actionner le résonateur mécanique d'un MOEMS par effet piézoélectrique (dit actionnement piézoélectrique), c'est à dire une structure comprenant un résonateur mécanique avec une lecture optique et un actionnement piézoélectrique. De tels systèmes ont plusieurs champs d'application, allant des capteurs résonants aux bases de temps en passant par les convertisseurs de fréquence. Dans de tels systèmes, l'actionnement piézoélectrique est lié à l'effet piézoélectrique inverse qui prévoit la déformation mécanique d'un matériau lorsque celui-ci est soumis à un champ électrique. Il s'agit d'une technique standard d'actionnement dans le domaine des microsystèmes, que ce soit pour des structures mécaniques résonantes ou statiques.

L'actionnement piézoélectrique nécessite de pouvoir générer un champ électrique, ce champ pouvant par exemple être généré en appliquant un potentiel entre deux électrodes ou par la mise en mouvement de porteurs de charge électrique (c'est le cas par exemple des résonateurs micro-ondes de type circuits inductance capacitance (LC) ou résistance-capacitance (RC) qui peuvent servir de structures d'actionnement).

Cependant, lorsque l'élément à actionner est un résonateur optomécanique, alors l'actionnement doit suivre un ensemble de règles strictes. Premièrement, par définition, un résonateur mécanique doit être disposé dans une cavité permettant son libre mouvement. Cette cavité peut donc être vide, remplie d'un gaz ou d'un liquide. Le positionnement de la structure d'actionnement doit donc veiller à perturber le moins possible le champ de déplacement mécanique du résonateur. Deuxièmement, le résonateur mécanique peut également agir comme une cavité optique, de façon qu'une onde électromagnétique se propage en son sein. Cette onde comprend une composante évanescente située hors de la cavité, ayant une décroissante spatiale exponentielle. Si cette portion évanescente est couplée avec un métal, celle-ci se retrouve absorbée. Dans ce contexte, il n'est donc pas possible de disposer des électrodes d'actionnement sur le résonateur opto-mécanique, ni dans son proche voisinage. Troisièmement, afin de générer de forts champs électriques de manière reproductible, il est nécessaire de maîtriser la distance entre les électrodes d'actionnement et le résonateur opto-mécanique. Il est donc important d'avoir un moyen d'actionnement compatible avec les procédés de micro-fabrication électronique, de manière à ce que tout soit directement intégré sur une même puce. Dans l'état de la technique, il existe plusieurs types d'actionnement en fonction de la structure du résonateur opto-mécanique.

Dans certaines structures de l'état de la technique, les systèmes opto-mécaniques peuvent être structurellement dissociés : la cavité optique et le résonateur mécanique sont réalisés à l'aide de deux éléments distincts. L'actionnement mécanique peut ainsi se faire par contact direct entre des électrodes d'actionnement et le résonateur mécanique. Deux géométries standards consistent à « sandwicher » le matériau piézoélectrique entre deux électrodes de polarisations électriques différentes, afin d'exciter un mode acoustique de volume (Film bulk acoustic resonator, ou FBAR, en en terminologie anglo-saxonne), ou bien de déposer des électrodes interdigitées sur la surface du résonateur mécanique afin de générer un couplage avec des ondes acoustiques de surfaces (SAW en terminologie anglo-saxonne). Cependant, dans ce cas de figure, les électrodes ont tendance à perturber les mouvements du résonateur mécanique et donc ses propriétés de résonance.

Dans d'autres structures de l'état de la technique, un actionnement via un élément provenant d'une seconde puce est mis en oeuvre. Il s'agit typiquement du cas pour lequel l'actionnement n'est pas réalisé via des électrodes mais par un résonateur micro-ondes. Ces derniers, généralement conçus via un matériau supraconducteur, ont des modes de résonances électromagnétiques. Ces modes comprennent une onde micro-onde confinée et guidée, se propageant dans la structure, ainsi qu'une composante évanescente autour de la structure. Malgré une décroissance spatiale exponentielle, la faible fréquence des ondes micrométriques permet la présence d'un champ électrique d'intensité suffisante pour pouvoir actionner une structure mécanique à plusieurs dizaines de micromètres du résonateur supraconducteur. A cette distance, la composante évanescente de l'onde optique (de fréquence bien plus élevée) est complètement éteinte, n'induisant ainsi pas de pertes supplémentaires. Cependant, dans l'état de la technique, ces résonateurs supraconducteurs sont conçus sur des puces différentes, permettant de simplifier le procédé de fabrication mais rendant l'alignement plus difficile et la reproductibilité des mesures plus incertaine.

En outre, en plus des difficultés déjà décrites, il convient de tenir compte de l'une des particularités de l'actionnement piézoélectrique : l'orientation vectorielle du couplage. En effet, sous l'effet d'un champ électrique, chaque matériau va subir une contrainte normale ou une contrainte de cisaillement dans une certaine direction de l'espace, elles-mêmes dépendantes de l'orientation du champ électrique. Pour obtenir un actionnement efficace, il est donc nécessaire d'aligner le champ électrique selon un axe défini prenant en compte la déformation souhaitée. Le tenseur piézoélectrique d'un matériau permet de faire le lien entre ces deux grandeurs. Il est lié à la structure cristallographique du matériau en question.

Dans les structures d'actionnement directement intégrées de l'état de la technique, les champs électriques présentent une composante principale horizontale relativement à la surface du substrat. Par exemple, Fong et al. dans « Microwaveassisted cohérent and nonlinear control in cavity piezo-optomechanical systems » dispose des électrodes dans le même plan que le résonateur optomécanique. Une variante développée par Zou et al. dans « Cavity piezomechanical strong coupling and frequency conversion on an aluminum nitride chip » consiste à abaisser l'une des deux électrodes au niveau du substrat. Le champ électrique devient transverse, le résonateur mécanique étant alors soumis à la fois à la composante verticale et horizontale du champ électrique. Une fraction de l'intensité du champ électrique est alors non couplée avec le matériau, rendant cette géométrie peu efficace. Dans une structure quelque peu différente (puisqu'aucun résonateur mécanique n'est présent, les auteurs effectuant de la modulation électro-optique), Wang et al. dans « On-Chip Optical Microresonators With High Electro-Optic Tuning Efficiency » proposent de déposer une couche de métal sur les portions du résonateur optique qui ne sont pas traversées par l'onde optique (ici les bords du disque uniquement sont sensibles). Au prix d'une large complexité technologique pour venir chercher le contact électrique, cette alternative est très spécifique au cas des disques qui confinent l'onde sur des portions localisées du résonateur. De plus, le métal étant en contact direct avec la cavité optique, dans le cas où celle-ci est également un résonateur mécanique, des pertes additionnelles sont à prévoir.

Ainsi, aucune des structures de l'état de la technique ne permet de répondre aux exigences relatives à l'actionnement d'un résonateur opto-mécanique.

### RESUME DE L'INVENTION

L'invention offre une solution aux problèmes évoqués précédemment, en proposant une structure qui permet de répondre aux exigences relatives à l'actionnement piézoélectrique d'un résonateur opto-mécanique.

Pour cela, un premier aspect de l'invention concerne une structure optomécanique comportant :
- Un substrat s'étendant selon un plan ;
- Un élément support agencé sur le substrat ;
- Au moins un élément conducteur adapté pour créer un champ électrique orienté perpendiculairement au plan du substrat ;
- Un résonateur opto-mécanique comportant :
   - Un élément mobile mécaniquement réalisé dans un matériau piézoélectrique et agencé sur l'élément support, le matériau piézoélectrique étant choisi de sorte que le champ électrique créé par l'élément conducteur lorsque ce dernier est soumis à un potentiel électrique entraîne un déplacement dudit élément mobile ;
   - Un résonateur optique couplé à l'élément mobile ;

Ledit au moins un élément conducteur étant situé au-dessus et/ou au-dessous dudit élément mobile, à une distance non nulle dudit élément mobile, ledit élément conducteur et ledit élément mobile ayant au moins une surface en regard l'une de l'autre.

Grâce à l'invention, le ou les éléments conducteurs en charge de l'actionnement ne sont pas en contact direct avec l'élément mobile (et donc le résonateur mécanique). Ils permettent donc un mouvement libre de ce dernier et éliminent le risque d'absorption d'ondes évanescentes lorsque de telles ondes sont utilisées pour la lecture. En outre, le ou les moyens d'actionnement sont situés au-dessus et/ou au-dessous de l'élément mobile, ce qui permet de générer un champ électrique d'actionnement perpendiculaire à l'élément mobile et non plus parallèle ou oblique comme dans l'état de la technique. Cette liste d'avantages n'est bien entendu pas exhaustive et d'autres avantages apparaîtront également dans la description détaillée de l'invention.

Outre les caractéristiques qui viennent d'être évoquées dans le paragraphe précédent, la structure selon un premier aspect de l'invention peut présenter une ou plusieurs caractéristiques complémentaires parmi les suivantes, considérées individuellement ou selon toutes les combinaisons techniquement possibles.

Dans un mode de réalisation, l'élément conducteur est un résonateur micro-onde ou une électrode.

Dans un mode de réalisation, la structure opto-mécanique comprend au moins deux éléments conducteurs, un premier élément conducteur situé au-dessous de l'élément mobile et un deuxième élément conducteur situé au-dessus de l'élément mobile.

Dans un mode de réalisation, l'élément mobile et le résonateur optique sont formés au moyen d'un cristal phoxonique.

Dans un mode de réalisation, le résonateur optique est un résonateur à mode de galerie, l'élément mobile étant intégré au résonateur optique. En effet, le résonateur à mode de galerie étant partiellement ou complètement suspendu, il forme également un élément mobile.

Dans un mode de réalisation, le résonateur opto-mécanique comprend un guide d'onde parcourant la périphérie d'une structure centrale, le guide d'onde étant relié à la structure centrale par des ancrages, une partie du guide d'onde formant l'élément mobile. On notera que, dans cette structure, le guide d'onde étant rebouclé sur lui-même, il forme un résonateur optique.

Dans un mode de réalisation, l'élément conducteur comprend une pluralité d'électrodes, lesdites électrodes étant situées, au moins en partie, en regard de l'élément mobile.

Un deuxième aspect de l'invention concerne un procédé de fabrication d'une structure selon un premier aspect de l'invention comprenant, à partir d'un substrat semi-conducteur :
- une étape de dépôt d'une couche d'un premier matériau sur le substrat ;
- une étape de formation d'un élément mobile dans un matériau piézoélectrique ;
- une étape de dépôt d'un deuxième matériau sur la couche de premier matériau et sur l'élément mobile ;
- une étape de formation d'un élément conducteur dans la couche de deuxième matériau ;
- une étape de gravure isotrope de la couche du premier matériau et de la couche du deuxième matériau de sorte à libérer l'élément mobile.

Dans un mode de réalisation, la structure comporte un premier élément conducteur et un deuxième élément conducteur, le procédé comprenant, avant étape de dépôt d'une couche d'un premier matériau sur le substrat, une étape de réalisation d'un premier élément conducteur au niveau du substrat, l'élément conducteur dans la couche de deuxième matériau formant le deuxième élément conducteur.

Un troisième aspect de l'invention concerne un procédé de fabrication d'une structure selon un premier aspect de l'invention comprenant, à partir d'un substrat semi-conducteur :
- une étape de dépôt d'une couche d'un premier matériau sur le substrat ;
- une étape de formation d'un élément conducteur dans la couche de premier matériau ;
- une étape de dépôt d'une couche d'un deuxième matériau sur la couche de premier matériau et sur l'élément conducteur ;
- une étape de formation d'un élément mobile dans un matériau piézoélectrique ;
- une étape de gravure isotrope de la couche du deuxième matériau de sorte à libérer l'élément mobile.

Dans un mode de réalisation, lors de l'étape de gravure isotrope, la couche du premier matériau est également gravée de sorte à libérer l'élément conducteur.

Dans un mode de réalisation, le résonateur optique est réalisé à l'aide d'un élément distinct de l'élément mobile et l'étape de formation d'un élément mobile comprend également la formation d'un résonateur optique.

L'invention et ses différentes applications seront mieux comprises à la lecture de la description qui suit et à l'examen des figures qui l'accompagnent.

### BREVE DESCRIPTION DES FIGURES

Les figures sont présentées à titre indicatif et nullement limitatif de l'invention.

La [Fig. 1A] et la [Fig. 1B] montrent une représentation schématique d'une structure selon l'invention.

La [Fig. 2A] et la [Fig. 2B] montrent de manière schématique un mode de réalisation dans lequel le résonateur opto-mécanique est à la fois un résonateur à modes (optiques) de galerie et un résonateur à modes (mécaniques) de respiration.

La [Fig. 3] montre de manière schématique un mode de réalisation dans lequel le résonateur opto-mécanique est réalisé au moyen d'une poutre insérée dans une cavité optique.

La [Fig. 4] montre de manière schématique un mode de réalisation dans lequel le résonateur opto-mécanique est un cristal phoxonique.

La [Fig. 5] montre de manière schématique un mode de réalisation dans lequel le résonateur opto-mécanique est réalisé à l'aide d'un résonateur mécanique et optique découplés mécaniquement.

La [Fig. 6A], la [Fig. 6B], la [Fig. 7] et la [Fig. 8] montrent de manière schématique différentes géométries que peuvent adopter le ou les éléments conducteurs.

La [Fig. 9] et les [Fig. 10A] à [Fig. 10L] montrent de manière schématique un premier procédé de fabrication.

La [Fig. 11] et les [Fig. 12A] à [Fig. 12H] montrent de manière schématique un deuxième procédé de fabrication.

### DESCRIPTION DETAILLEE

Sauf précision contraire, un même élément apparaissant sur des figures différentes présente une référence unique.

### Structure opto-mécanique

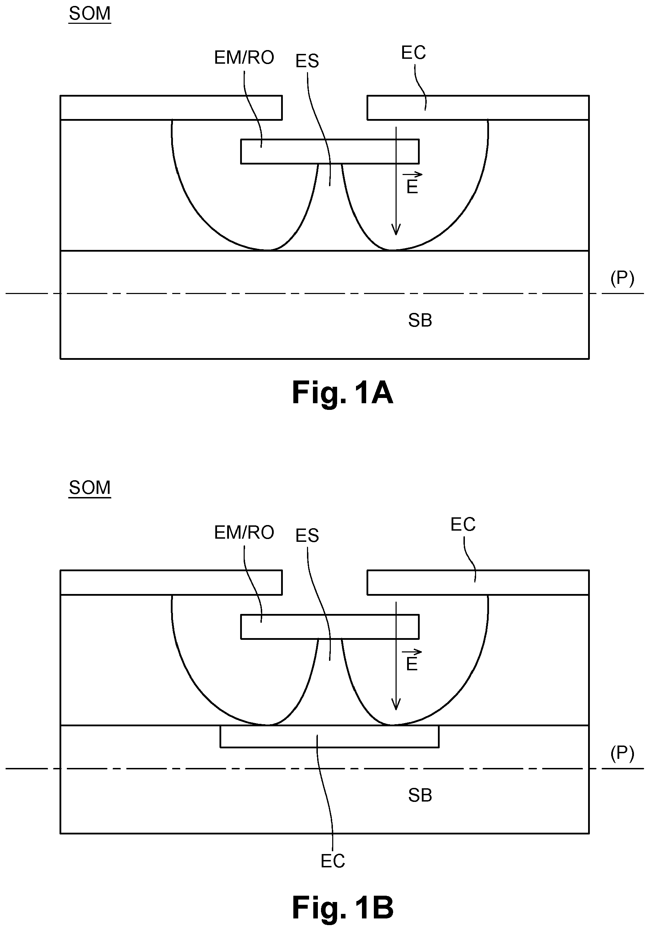

Comme illustré à la [Fig. 1A] et à la [Fig. 1B], un premier aspect de l'invention concerne une structure opto-mécanique SOM comportant un substrat SB s'étendant selon un plan P, un élément support ES agencé sur le substrat SB, au moins un élément conducteur EC adapté pour créer un champ électrique orienté perpendiculairement au plan P du substrat SB.

Dans la présente description, on entend par « orienté perpendiculairement » que l'angle associé est compris entre 65 et 115 degrés, et de préférence entre 85 et 95 degrés. L'angle considéré ici pour le champ électrique est par exemple l'angle défini entre la direction du champ électrique et le plan P du substrat SB.

La structure opto-mécanique SOM comprend également un résonateur opto-mécanique comportant un élément mobile mécaniquement EM, ci-après élément mobile EM, réalisé dans un matériau piézoélectrique et agencé sur l'élément support ES, et un résonateur optique RO couplé à l'élément mobile EM. Ainsi, le résonateur optique RO et l'élément mobile EM forment un résonateur optomécanique.

Sur la [Fig. 1A] et la [Fig. 1B], l'élément mobile EM piézoélectrique est également un résonateur optique RO de sorte qu'il forme, à lui seul, un résonateur opto-mécanique. Dans d'autres modes de réalisation illustrés dans la suite, l'élément mobile EM et le résonateur optique RO peuvent être réalisés dans des éléments distincts, éventuellement constitués de matériaux différents.

De plus, dans la structure SOM selon l'invention, le matériau piézoélectrique de l'élément mobile EM est choisi de sorte que le champ électrique *̅E̅*̅ créé par l'élément conducteur EC ou les éléments conducteurs EC, lorsque ce dernier ou ces derniers sont soumis à un potentiel électrique, entraîne un déplacement dudit élément mobile EM. On notera que le déplacement engendré par un champ électrique *̅E̅*̅ donné n'est pas nécessairement colinéaire audit champ électrique *̅E̅*̅.

Dans un mode de réalisation illustré à la [Fig. 1A], la structure SOM selon l'invention comprend un seul élément conducteur EC, cet élément conducteur EC étant situé au-dessus ou au-dessous de l'élément mobile EM, à une distance non nulle dudit élément mobile EM, ledit élément conducteur EC et ledit élément mobile EM ayant une surface en regard l'une de l'autre.

Dans la présente description, on entend par l'expression « une surface en regard d'une autre » que les deux surfaces concernées sont placées, au moins en partie, en face de l'une de l'autre. Plus particulièrement, il est par exemple possible de définir une surface de recouvrement qui correspond à la zone de chacune des surfaces concernées effectivement positionnées l'une en face de l'autre. Ici, cette surface de recouvrement représente au moins 5% de chacune des surfaces concernées. De préférence, cette surface de recouvrement représente au moins 15% de chacune des surfaces concernées. De préférence encore, cette surface de recouvrement représente au moins 30% de chacune des surfaces concernées.

En d'autres termes, ici, une surface de recouvrement est définie entre l'élément conducteur EC et l'élément mobile EM de telle sorte que ces deux éléments aient une surface (au moins en partie) en regard l'une de l'autre. Cette surface de recouvrement correspond à la partie de la surface de l'élément conducteur EC ou à la partie de la surface de l'élément mobile EM qui se font face.

Dans ce mode de réalisation, l'élément conducteur EC forme un résonateur micro-onde configuré de sorte à générer le champ électrique *̅E̅*̅.

Dans un mode de réalisation alternatif (et préférentiel) illustré à la [Fig. 1B], la structure selon l'invention comprend deux éléments conducteurs EC : un premier élément conducteur EC situé au-dessus de l'élément mobile EM et un deuxième élément conducteur EC situé au-dessous de l'élément mobile EM, l'un au moins de ces deux éléments conducteurs EC, de préférence les deux éléments conducteurs EC, ayant une partie en regard d'une partie de l'élément mobile EM. Bien entendu, il est également possible d'imaginer une telle structure avec trois éléments conducteurs EC ou plus.

Dans la structure SOM selon l'invention, lorsque l'élément mobile EM est situé dans une cavité, celle-ci peut être remplie d'un gaz, d'un liquide ou bien laissée sous vide (c'est à dire à une pression inférieure au mbar). De plus, dans la structure SOM selon l'invention, le ou les éléments conducteurs EC qui sont chargés de l'actionnement de l'élément mobile EM ne sont pas en contact avec l'élément mobile EM et ne viennent donc pas perturber son mouvement. En outre, lorsque le couplage entre l'élément mobile EM et le résonateur optique RO se fait par l'intermédiaire d'ondes évanescentes, le risque de voir lesdites ondes partiellement ou totalement absorbées par le ou les éléments conducteurs EC est fortement réduit.

De plus, la structure selon l'invention SOM, en étant compatible avec les procédés de micro-fabrication électronique, permet de maîtriser la distance entre l'élément mobile EM et le ou les éléments conducteurs EC et ainsi générer de forts champs électriques au niveau de l'élément mobile EM, et ce de manière reproductible.

### Principe de fonctionnement

Un résonateur opto-mécanique comprend en général un élément mobile EM susceptible de bouger (par exemple, pour vibrer à une fréquence donnée) propre et un moyen de lecture optique de ce mouvement, en général un résonateur optique RO (ou cavité optique).

Dans un premier exemple de fonctionnement, la structure comprend deux éléments conducteurs EC situés au-dessus et au-dessous de l'élément mobile EM, l'un au moins de ces deux éléments conducteurs ayant une partie en regard d'une partie de l'élément mobile EM, les deux éléments conducteurs EC sont portées à des polarisations électriques différentes, induisant la création d'un champ électrique *̅E̅*̅ homogène entre les éléments conducteurs EC. En reprenant le schéma de la [Fig. 1B], l'élément mobile EM est traversé par des lignes de champs électrique *̅E̅*̅ sensiblement (+/-20°, voire +/- 10°) verticales relativement à la surface du substrat SB. Il est alors possible d'obtenir par couplage piézoélectrique des déformations dans plusieurs directions de l'espace.

Dans un deuxième exemple de fonctionnement, la structure ne comprend qu'un élément conducteur EC formant un résonateur micro-ondes permettant. Le principe est similaire si ce n'est que le champ électrique *̅E̅*̅ est induit par une onde évanescente et que donc la décroissance de l'intensité dudit champ électrique *̅E̅*̅ est spatialement exponentielle, et non uniforme comme dans le cas précédent. Aussi, dans ce mode de réalisation, une attention particulière doit donc être portée à la distance séparant l'élément conducteur EC de l'élément mobile EM.

### Exemples de résonateurs opto-mécaniques selon l'invention

### Résonateur à mode de galerie

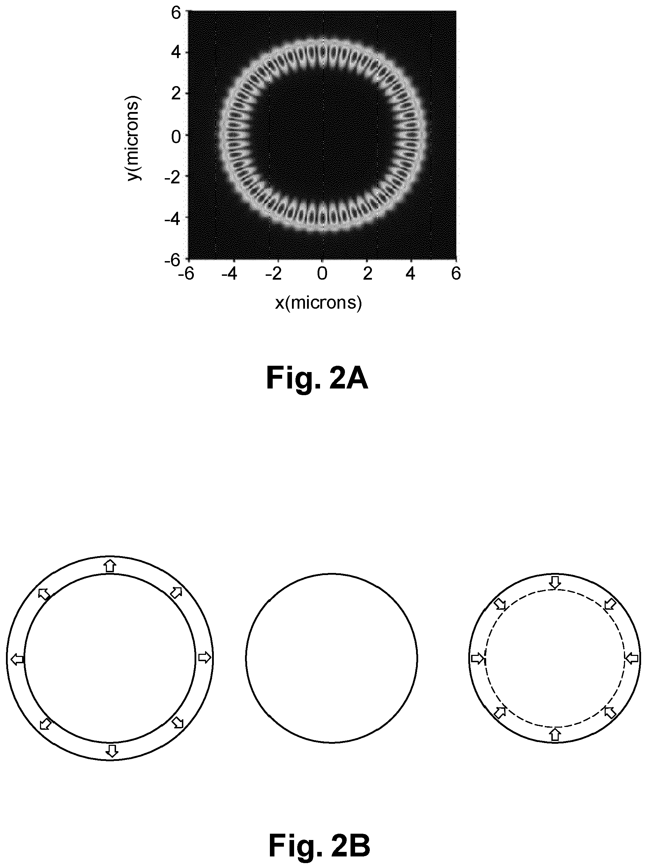

Dans un mode de réalisation illustré à la [Fig. 2A] et à la [Fig. 2B], l'élément mobile EM et le résonateur optique RO sont réalisés au moyen d'un résonateur à mode de galerie. Au sens strict du terme, les résonateurs à mode de galerie sont des résonateurs optiques présentant une géométrie permettant au mode optique de reboucler sur lui-même, par exemple une géométrie présentant une symétrie cylindrique ou sphérique. Ils peuvent également présenter des modes mécaniques afin de former des résonateurs opto-mécaniques. Par exemple, de tels résonateurs peuvent prendre la forme d'un anneau, d'une roue, d'un disque ou d'une sphère. De préférence, la lumière se propageant dans ce type de cavité est localisée aux extrémités de la structure comme illustré à la [Fig. 2A] qui montre l'intensité du champ électrique dans le plan de l'élément mobile EM dans le cas d'un élément mobile EM de forme circulaire. A chaque tour dans le résonateur, celle-ci interfère avec elle-même, donnant ainsi naissance à des interférences constructives. Le résonateur optique (ou cavité optique) ainsi obtenue filtre alors toutes les longueurs d'onde sauf celles répondant favorablement aux conditions d'interférences constructives.

Plusieurs modes de vibrations peuvent être exhibés. Préférentiellement, l'élément mobile EM vibre selon un mode de respiration illustré à la [Fig. 2B]. Ainsi, les longueurs d'ondes filtrées par le résonateur optique RO sont fonction des vibrations de l'élément mobile EM de sorte à former un résonateur opto-mécanique. Ces résonateurs présentent l'avantage de fournir un couplage très élevé, c'est-à-dire que pour un déplacement mécanique donné, le décalage de la longueur d'onde de résonance est élevé. Ce constat est particulièrement vrai pour un déplacement mécanique associé au mode de respiration mentionné précédemment dans le cas simple d'un disque, c'est-à-dire une déformation isotrope dans le plan de l'élément mobile EM.

Dans un mode de réalisation, l'élément mobile EM est réalisé dans du nitrure d'aluminium déposé sur de l'oxyde de silicium. Les conditions de dépôt impliquent une anisotropie du matériau selon l'axe perpendiculaire au plan (P) du substrat SB et une isotropie dans le plan parallèle au plan (P) du substrat. Pour actionner le premier mode de respiration décrit ci-dessus, il est alors nécessaire pour le matériau de se coupler à un champ électrique dont la composante verticale par rapport au plan du disque, c'est à dire au plan (P) du substrat, est non nulle.

### Poutre insérée dans une cavité optique

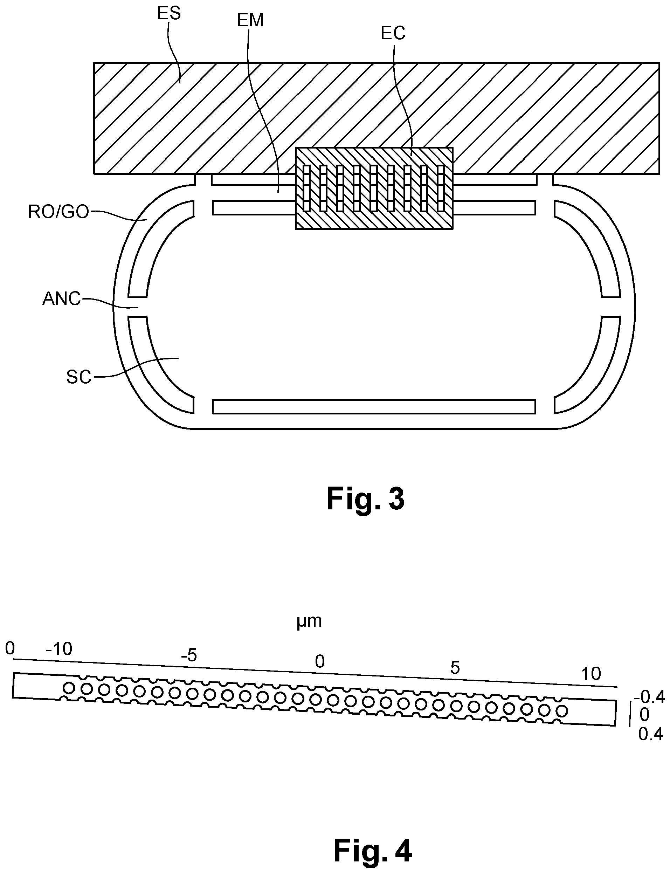

Dans un deuxième exemple de réalisation illustré à la [Fig. 3], le résonateur opto-mécanique comprend un guide d'onde GO parcourant la périphérie d'une structure centrale SC à laquelle il est relié par des ancrages AC, ledit guide d'onde GO formant un résonateur optique RO. De plus, l'ensemble est fabriqué dans une matériau piézoélectrique M3. Les ancrages sont disposés sur l'élément support ES. En outre, le guide d'onde GO comprend au moins une partie (de préférence aux moins deux parties) mobile agissant comme une poutre vibrante et venant former un élément mobile EM de la structure SOM selon l'invention. En d'autres termes, l'élément mobile EM est une partie constitutive du guide d'onde GO dans lequel se propage l'onde optique. Ainsi, une déformation de cet élément mobile EM entraîne une déformation et/ou une perturbation des propriétés optiques du guide d'onde GO, réalisant ainsi un couplage opto-mécanique. De préférence, l'élément mobile EM est rectiligne. Dans un mode de réalisation, la largeur du guide d'onde est comprise entre 200 nm et 1000 nm. Dans un mode de réalisation, la longueur du guide d'onde est comprise entre 5 µm et 50 µm. Dans un mode de réalisation, le rayon de courbure de la partir courbée du guide d'onde est comprise entre 5 µm et 50 µm. Dans un mode de réalisation, la largeur de l'élément conducteur EC (mesurée selon l'axe principal du guide d'onde GO au niveau dudit élément conducteur EC) est comprise entre 100 nm et la longueur séparant deux ventres de l'onde mécanique considérée de l'élément mobile EM.

La structure précédente prend généralement des géométries en piste de course (dénommé Racetrack en terminologie anglo-saxonne). C'est par exemple l'approche mise en oeuvre par Westwood-Bachman et al. dans « Integrated silicon photonics transduction of even nanomechanical modes in a doubly clamped beam », qui actionne une poutre doublement clampée grâce à une force optique (il n'y a donc pas d'actionnement piézoélectrique comme dans la présente invention). Par ailleurs, la structure selon l'invention comporte deux éléments conducteurs EC : un premier élément conducteur situé au-dessus d'une portion de l'élément mobile EM et un deuxième élément conducteur EC situé au-dessous d'une portion de l'élément mobile EM de sorte à pouvoir actionner l'élément mobile EM. Une telle configuration dans laquelle le déplacement de l'élément mobile EM est vertical par rapport au plan (P) du substrat (donc sensiblement parallèle au champ électrique généré par l'élément conducteur EC) offre en général un meilleur échange d'énergie (couplage electro-mécanique) que la configuration dans laquelle le déplacement est radial (par exemple avec résonateur en mode de galerie présenté précédemment).

Dans un mode de réalisation, l'un au moins des éléments conducteurs EC comprend une pluralité d'électrodes, lesdites électrodes étant situées, au moins en partie, en regard de l'élément mobile EM. Il est ainsi possible d'actionner sélectivement une harmonique de l'élément mobile EM en positionnant les électrodes de l'élément conducteur EC au-dessus des ventres de l'onde stationnaire de l'élément mobile EM.

Dans un autre mode de réalisation alternatif, les éléments conducteurs EC situés au-dessus et au-dessous de l'élément mobile EM sont des électrodes pleines. De plus, des ancrages sont disposés au niveau des zones de déplacement nul de l'élément mobile EM.

### Cristaux phoxoniques

Pour mémoire, les cristaux phoxoniques sont des résonateurs qui se comportent à la fois comme des cristaux photoniques (résonateurs optiques), c'est à dire des structures capables de confiner dans un volume restreint une onde optique, et des cristaux phononiques (résonateurs mécaniques), leur équivalent pour des ondes mécaniques. Le principe de ces cristaux repose sur la localisation, dans un même espace, d'un fort champ optique et d'un champ de déplacement mécanique. En général, ces structures comprennent un motif répété périodiquement dans l'espace, ainsi qu'un défaut artificiel dont l'objectif est de venir piéger les ondes optiques et mécaniques. Ces résonateurs sont bien connus dans le domaine de l'opto-mécanique et ne sont donc pas détaillés ici. Pour plus de détails, le lecteur pourra notamment se référer à l'article Ghorbel et al. 2019, « Optomechanical gigahertz oscillator made of a two photon absorption free piezoelectric III/V semiconductor »*.*

Dans un troisième exemple de réalisation, le résonateur opto-mécanique est un cristal phoxonique, par exemple une poutre configurée de sorte à former un cristal phoxonique telle qu'illustrée à la [Fig. 4]. Dans l'exemple de réalisation illustré à la [Fig. 4], le résonateur opto-mécanique est réalisé à l'aide d'une « maille bichromatique ». Plus particulièrement, dans ce mode de réalisation, le résonateur opto-mécanique comprend une poutre formant l'élément mobile EM et dans laquelle sont ménagées des ouvertures dans la partie centrale de la poutre et à sa périphérie de sorte à former un résonateur optique RO. De plus, l'espacement entre les ouvertures réalisées sur la partie centrale de la poutre et celles réalisées à sa périphérie est différent de sorte à obtenir un effet de confinement de l'onde mécanique et de l'onde optique. Dans un mode de réalisation, la poutre à une longueur comprise entre 5 µm et 50 µm, les ouvertures internes aménagées dans la poutre au niveau de sa partie centrale pour former le cristal phoxonique ont un rayon compris entre 100 nm et 500 nm, et les ouvertures externes aménagées dans la poutre au niveau de sa périphérie pour former le cristal phoxonique ont un rayon compris entre 50 nm et 200 nm.

La structure SOM selon l'invention présente l'avantage de permettre l'actionnement de ce type de résonateur de manière piézoélectrique en positionnant l'élément conducteur EC situé au-dessus de l'élément mobile EM et/ou l'élément conducteur EC situé au-dessous de l'élément mobile EM au niveau de la zone de déplacement mécanique de ce dernier (c'est-à-dire du cristal phoxonique), par exemple le centre de la poutre. Selon le tenseur piézoélectrique du matériau utilisé, le champ électrique vertical peut alors induire une déformation radiale du résonateur.

### Résonateur mécanique et optique découplés mécaniquement

Dans les exemples qui précèdent, il existe un couplage mécanique entre le résonateur optique RO et l'élément mobile EM. Il est cependant possible de réaliser un résonateur opto-mécanique dans lequel le couplage entre l'élément mobile EM (actionné piézoélectriquement) et le résonateur optique RO se fait par le biais d'une onde évanescente, ladite onde provenant du résonateur optique RO et interagissant avec l'élément mobile EM (via le champ électrique associé à ladite onde évanescente). Lorsque l'élément mobile EM et le résonateur optique RO sont une seule et même structure, le ou les éléments conducteurs EC en charge de l'actionnement de l'élément mobile EM peuvent perturber le champ optique, qui est assez proche, et dégrader la lecture.

L'invention, en permettant un couplage indirect (le couplage se fait par l'intermédiaire de l'élément mobile EM) des éléments conducteurs EC chargés de l'actionnement du résonateur optique RO, permet de prévenir les inconvénients énoncés précédemment. Dans cet exemple de réalisation, l'élément mobile EM est nécessairement dans un matériau piézoélectrique afin de permettre un actionnement de ce dernier, mais le résonateur optique RO peut être réalisé dans un matériau différent. Par exemple, la couche dans lequel est réalisé le résonateur opto-mécanique peut comporter deux sous-couches différentes : une sous-couche piézoélectrique (par exemple AlN) dans lequel est réalisé l'élément mobile EM et une sous-couche structurelle (par exemple en Si) qui présente des bonnes propriétés mécaniques et optiques et dans laquelle est réalisé le résonateur optique RO.

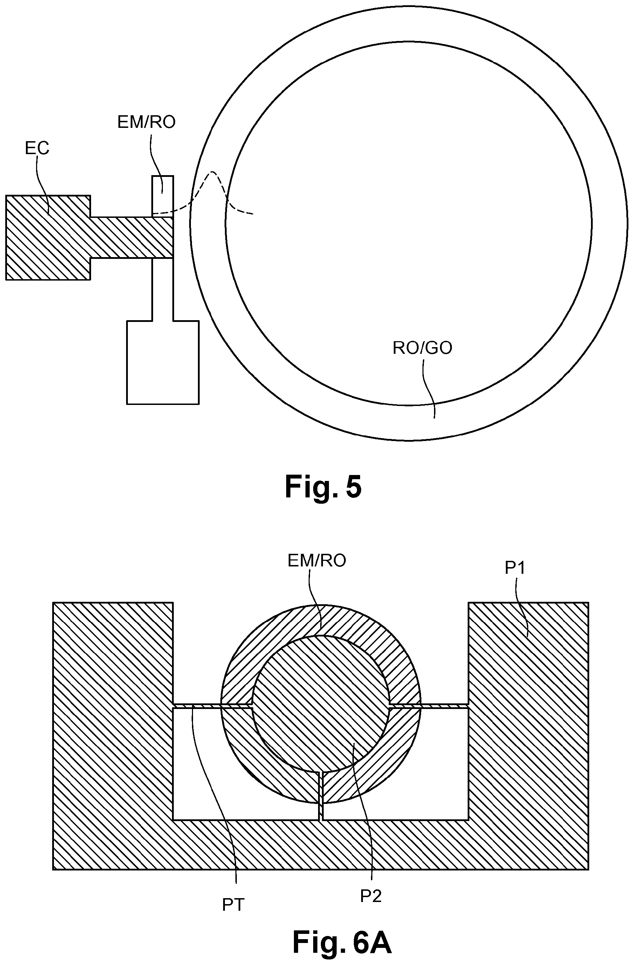

Un exemple de réalisation est illustré à la [Fig. 5], dans lequel le résonateur opto-mécanique comprend, en plus de l'élément mobile EM (agissant comme un résonateur mécanique), un guide d'onde GO en anneaux formant un résonateur optique RO, la distance séparant l'élément mobile EM du guide d'onde GO étant choisie de sorte à permettre un couplage entre le résonateur optique RO et l'élément mobile EM par l'intermédiaire d'une onde évanescente issue du guide d'onde GO. Un système similaire, mais sans actionnement piézoélectrique, est par exemple décrit dans le document Leoncino et al., « Optomechanical nanoresonator readout with optical downmixing », 2016 IEEE International Frequency Control Symposium (IFCS). Un actionnement piézoélectrique est notamment rendu possible par le fait que, dans la structure SOM selon l'invention, le ou les éléments conducteurs EC d'actionnement ne sont pas disposés au contact de l'élément mobile EM, ce qui évite une absorption de l'onde évanescente.

### Géométrie du ou des éléments conducteurs

Le ou les éléments conducteurs EC situés au-dessus de l'élément mobile EM peuvent adopter différentes géométries en fonction des contraintes et des applications.

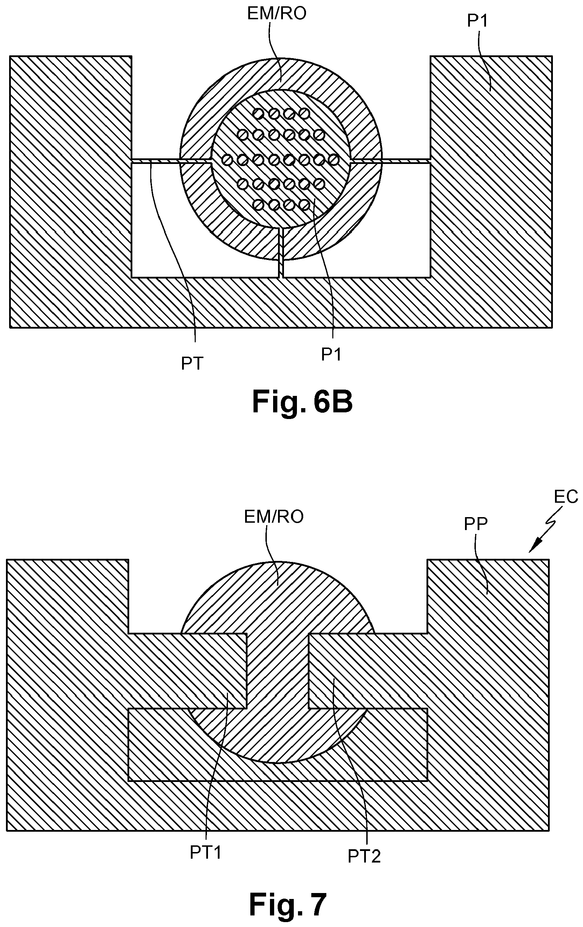

Dans un premier mode de réalisation illustré à la [Fig. 6A], l'élément mobile EM a la forme d'un disque dans un plan parallèle au plan P du substrat SB. De plus, l'élément conducteur EC situé au-dessus de l'élément mobile EM comprend une première partie P1 et une deuxième partie P2, la deuxième partie P2 en forme de disque, la première partie P1 entourant, au moins partiellement, la deuxième partie P2 et n'étant pas en regard de l'élément mobile EM, la deuxième partie P2 étant reliée à la première partie P1 par une ou plusieurs poutres PT et étant disposée en regard de l'élément mobile EM. De préférence, le centre de la deuxième partie P2 et le centre de l'élément mobile EM sont située sur un même axe, ledit axe étant perpendiculaire à l'élément mobile EM (c'est à dire perpendiculaire au plan P du substrat SB). De préférence, la surface de la deuxième partie P2 est inférieure à celle de l'élément mobile EM de sorte que la périphérie de l'élément mobile EM n'est pas en regard de la deuxième partie P2 (ou de la première partie P1). De préférence, comme illustré à la [Fig. 6B], des ouvertures traversantes sont réalisées dans la deuxième partie P2.

Dans un deuxième mode de réalisation illustré à la [Fig.7], l'élément mobile EM est en forme de disque, le disque étant disposé dans un plan parallèle au plan P du substrat SB. De plus, l'élément conducteur EC situé au-dessus de l'élément mobile EM comprend une partie principale PP entourant l'élément mécanique EM (sans être en regard de ce dernier) et servant d'ancrage, et au moins une électrode, de préférence deux électrodes, reliées à la partie principale PP, une partie de la surface desdites électrode PT1,PT2 étant en regard de l'élément mobile EM. De préférence, des ouvertures traversantes sont réalisées dans la ou les électrodes PT1,PT2, au moins dans la partie en regard avec l'élément mobile EM.

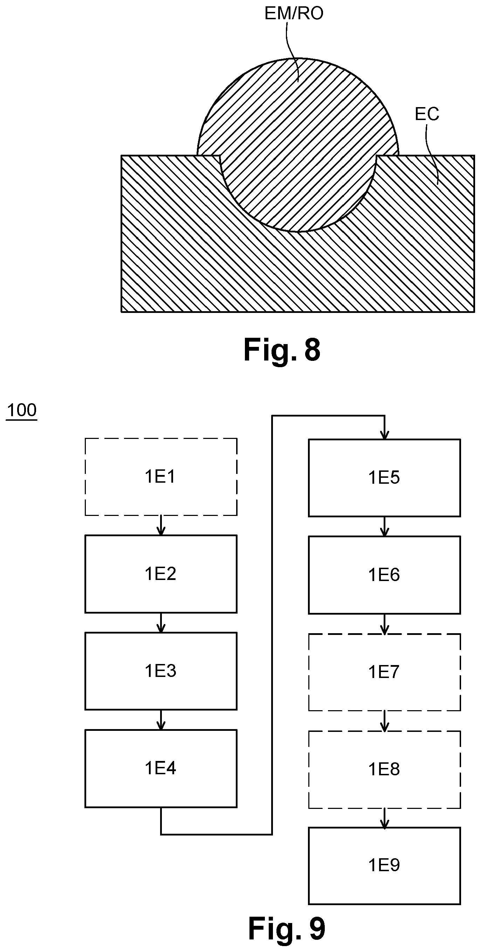

Dans un troisième mode de réalisation illustré à la [Fig. 8], l'élément mobile EM est en forme de disque, le disque étant disposé dans un plan parallèle au plan P du substrat SB. De plus, l'élément conducteur EC situé au-dessus de l'élément mobile EM est configuré de sorte à être en regard d'au moins une partie de la périphérie dudit élément mobile EM. Autrement dit, l'élément conducteur EC situé au-dessus de l'élément mobile EM n'est pas en regard de la partie centrale de l'élément mobile EM et, de préférence, n'est en regard que d'une partie seulement de la périphérie dudit élément mobile EM. De préférence, des ouvertures traversantes sont réalisées dans l'élément conducteur EC situé au-dessus de l'élément mobile EM, au moins dans la partie en regard avec l'élément mobile EM.

Les géométries décrites précédemment sont particulièrement adaptées au résonateur à mode de galerie, en particulier lorsque ce dernier prend la forme d'un disque comme décrit précédemment.

On notera que toutes ces géométries concernent l'élément conducteur EC situé au-dessus de l'élément mobile EM (c'est à dire que l'élément mobile EM est dans un plan situé entre l'élément conducteur EC considéré et le substrat SB) et qu'un élément conducteur EC (non représenté sur les figures) est également disposé au-dessous de l'élément mobile EM (c'est à dire que l'élément conducteur EC considéré est dans un plan situé entre l'élément mobile EM et le substrat SB ou directement dans le substrat SB). Dans un mode de réalisation, l'élément conducteur EC situé au-dessous est configuré pour créer, avec l'élément conducteur EC situé au-dessus, un champ électrique dans la direction la plus couplée piézoélectriquement de sorte à favoriser le couplage électromécanique de l'élément mobile EM. Par exemple, si le matériau piézoélectrique est le AlN, le champ électrique sera de préférence hors-plan par rapport au substrat. Dans un mode de réalisation, l'élément conducteur EC situé au-dessous possède la même géométrie circulaire que l'élément mobile EM (en forme de disque).

### Applications possibles

Une structure SOM selon l'invention peut être utilisée dans de nombreuses applications dont certaines seulement seront détaillées dans la suite.

Une structure SOM selon l'invention peut être utilisée dans un capteur résonant. Pour mémoire, la fréquence propre d'un résonateur mécanique dépend de plusieurs paramètres mesurables (masse, accélération, pression...). Aussi, la variation de l'un de ces paramètres induit un décalage de la fréquence de l'oscillateur. La quantification de ce décalage permet ainsi de remonter à la grandeur mesurée. Les capteurs résonants doivent avoir des systèmes d'actionnement performants capables de générer une amplitude de déplacement mécanique la plus élevée possible, couplée à une fréquence mécanique également élevée.

Une structure SOM selon l'invention peut également être utilisée dans un générateur de base de temps. Pour mémoire, le fonctionnement des bases de temps est opposé à celui des capteurs résonants : l'objectif étant de garder une fréquence la plus stable possible. Ces bases de temps servent notamment en électronique numérique et dans les télécommunications pour générer des signaux et synchroniser les différents composants. Dans ces systèmes, l'actionnement est primordial pour utiliser toute la gamme dynamique utilisable, c'est-à-dire utiliser un signal avec l'amplitude la plus large possible.

Une structure SOM selon l'invention peut encore être utilisée dans un convertisseur de fréquence. Pour rappel, les convertisseurs de fréquence sont notamment utilisés dans le cadre des technologies de l'information quantique. Ils servent à convertir des photons dans la gamme de micro-ondes en photons dans la gamme optique (visible et proche infrarouge) et vice versa. La conversion s'effectue en couplant un résonateur micro-ondes et un résonateur opto-mécanique. Les photons micro-ondes en entrée du système résonnent à leur fréquence propre dans une cavité supraconductrice et actionnent le résonateur mécanique. Un système de transduction optique permet ensuite de récupérer un signal optique modulé à la fréquence de résonance des photons micro-ondes.

Une structure SOM selon l'invention peut aussi être utilisée dans un capteur statique. Dans un tel capteur, l'élément mécanique n'est pas un résonateur, mais il est libre de se déformer et perturber le champ optique. Ce cas de figure décrit les capteurs dits statiques (d'accélération, de pression, etc.) avec une lecture opto-mécanique. Dans plusieurs cas de figure, un actionnement de l'élément mobile EM (par exemple, piézoélectrique) doit être utilisé pour effectuer des fonctions de compensation de dérives ou de décalage statique.

### Procédés de fabrication

### Premier procédé

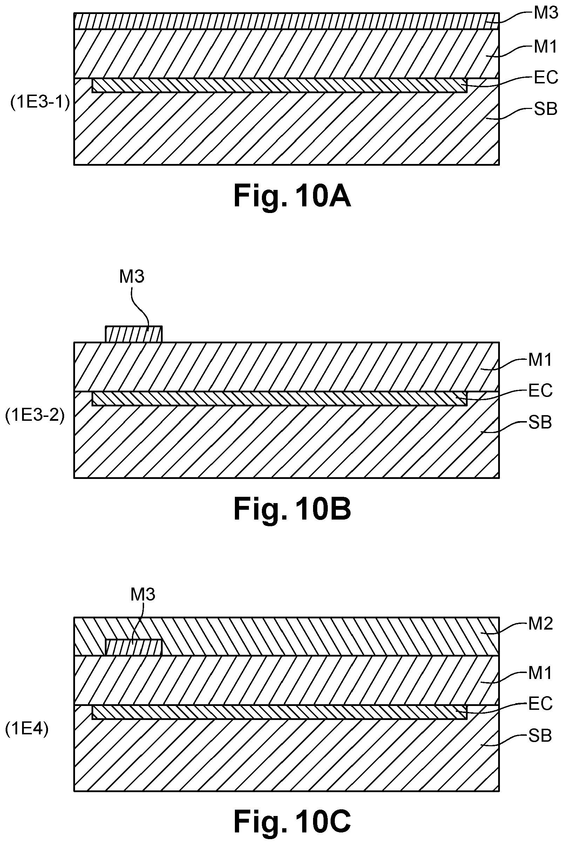

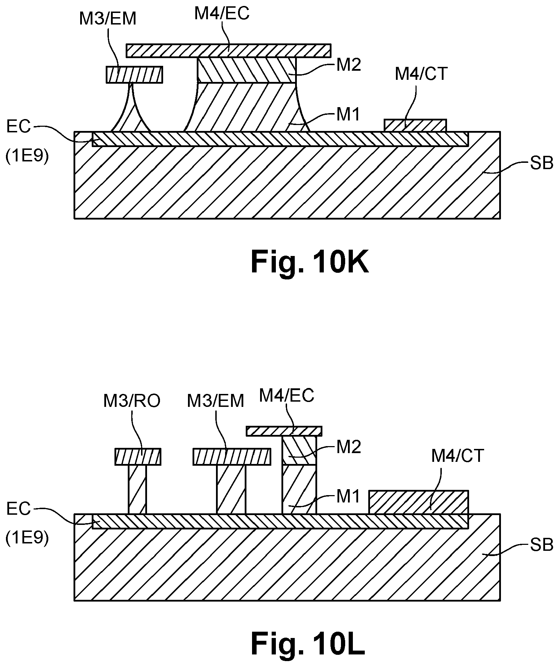

Un deuxième aspect de l'invention illustré aux [Fig. 9] et [Fig. 10A] à [Fig. 10L] concerne un premier procédé 100 de fabrication d'une structure SOM selon l'invention, le procédé 100 en question étant réalisé à partir d'un substrat semi-conducteur SB, de préférence un substrat SB en silicium.

Dans un mode de réalisation, le procédé 100 comprend une étape 1E1 de réalisation d'un premier élément conducteur EC au niveau du substrat SB. Dans un exemple de réalisation, cet élément conducteur EC est obtenu par un dopage d'une partie au moins du substrat SB de sorte à définir ledit élément conducteur EC dans ledit substrat SB. De manière alternative, cet élément conducteur EC est obtenu par le dépôt d'une couche de métal à la surface du substrat de sorte à former ledit élément conducteur.

Le procédé comprend une étape 1E2 de dépôt (physique ou chimique) d'une couche d'un premier matériau M1 sur le substrat SB. Dans un mode de réalisation, la couche ainsi déposée a une épaisseur comprise entre 1 µm et 2 µm, de préférence égale à 1.5 µm. Cette couche du premier matériau M1 est destinée à fournir un support structurel à l'élément mobile et donc au résonateur opto-mécanique. De préférence, le premier matériau est choisi de sorte à pouvoir être gravé de manière isotrope afin de pouvoir (dans les étapes suivantes) libérer l'élément mobile de sorte que ce dernier puisse vibrer librement. Dans un exemple de réalisation, le premier matériau M1 est de l'oxyde de silicium (SiO₂) ou un alliage d'aluminium, de gallium et d'arsenic (AlGaAs), ces matériaux pouvant par exemple être gravés à l'aide d'acide hydrofluorique (HF).

Le procédé comprend ensuite une étape 1E3 de formation d'un élément mobile EM, et éventuellement d'un résonateur optique RO, dans un matériau piézoélectrique M3. Dans un mode de réalisation, la couche de matériau piézoélectrique déposée lors de cette étape 1E3 a une épaisseur comprise entre 0.3 µm et 0.4 µm, de préférence égale à 0.35 µm. De préférence, le matériau piézoélectrique M3 est un diélectrique de sorte à permettre le passage d'une onde électromagnétique. Le matériau piézoélectrique M3 est également choisi de sorte à résister à la gravure du premier matériau M1 ou du deuxième matériau M2 (introduit dans la suite). Dans un exemple de réalisation, le matériau piézoélectrique M3 est le nitrure d'aluminium (AlN), le niobate de lithium (LiNbO3 ou LNO pour lithium-niobium-oxide en anglais), ou le lithium-titanate (ou LTO pour lithium-titanium-oxide en anglais). Comme illustré à la [Fig. 10B], lorsque l'étape 1E1 de réalisation d'un premier élément conducteur EC au niveau du substrat est mise en oeuvre, alors l'élément mobile EM formé lors de cette étape 1E3 à au moins une partie (dans l'exemple de la [Fig. 10B] la totalité) en regard dudit premier élément conducteur EC.

Dans un mode de réalisation illustré aux [Fig. 10A] et [Fig. 10B], cette étape 1E3 de formation d'un élément mobile EM dans un matériau piézoélectrique M3 comprend tout d'abord une sous-étape 1E3-1 de dépôt (voir [Fig. 10A]), sur la couche du premier matériau M1, d'une couche du matériau piézoélectrique M3 (un dépôt est particulièrement adapté lorsque le matériau M1 est le AlN). Elle comprend également une sous-étape de lithographie de sorte à définir les motifs de l'élément mobile EM et, éventuellement, du résonateur optique RO. Elle comprend enfin une sous-étape 1E3-2 de gravure de la couche du matériau piézoélectrique M3 (voir [Fig. 10B]) de sorte à transférer dans ladite couche les motifs définis lors de la sous-étape de lithographie. Dans une variante de ce mode de réalisation, la couche de premier matériau M1 n'est pas déposée mais collée à l'aide d'une technique de type smartcut^{™}. Cette variante est particulièrement adaptée lorsque le matériau M1 est le LNO ou le LTO.

Comme illustré à la [Fig. 10C], le procédé 100 comprend ensuite une étape 1E4 de dépôt d'un deuxième matériau M2 sur la couche de premier matériau M1 et sur l'élément mobile EM. Dans un mode de réalisation, le deuxième matériau M2 est identique au premier matériau M1. Dans un mode de réalisation, l'épaisseur de la couche de deuxième matériau M2 déposée lors de cette étape 1E4 est comprise entre 0.5 µm et 5 µm, de préférence égale à 1.05 µm.

Le procédé 100 comprend ensuite une étape 1E5 de formation d'un deuxième élément conducteur EC (par exemple une électrode ou un résonateur micro-onde) dans un matériau conducteur M4 (ce matériau pouvant être supraconducteur), dans la couche de deuxième matériau M2. Dans un mode de réalisation, l'épaisseur du deuxième élément conducteur EC est comprise entre 0.4 µm et 1 µm, de préférence égale à 0.5 µm. Dans un mode de réalisation, la distance séparant l'élément conducteur EC de l'élément mobile EM et, lorsqu'il est distinct de l'élément mobile EM, le résonateur optique RO, est comprise entre 400 nm et 900 nm, de préférence égale à 700 nm.

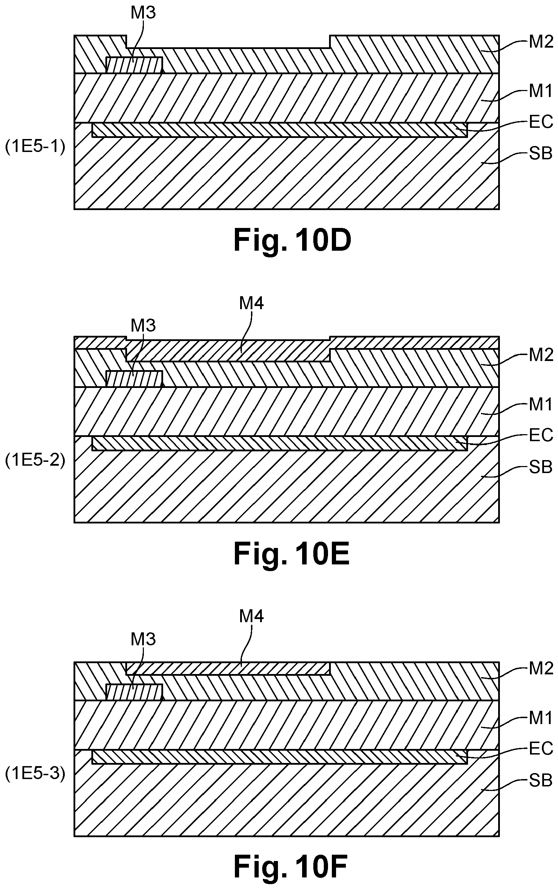

Dans un mode de réalisation illustré aux [Fig. 10D] à [Fig. 10F], l'étape 1E5 de formation d'un deuxième élément conducteur EC dans la couche de deuxième matériau M2 est réalisée à l'aide d'un procédé Damascène bien connue de l'homme du métier. Plus particulièrement, cette étape 1E5 comprend d'abord une sous-étape de lithographie de sorte à définir les motifs de l'élément conducteur EC. Cette étape 1E5 comprend ensuite une sous-étape 1E5-1 de gravure partielle de la couche du deuxième matériau M2 selon les motifs définis lors de l'étape de lithographie ([Fig. 10D]), l'épaisseur restante après gravure étant supérieure à l'épaisseur de l'élément mobile EM. Elle comprend ensuite une sous-étape 1E5-2 de dépôt d'une couche d'un matériau conducteur M4 sur la couche d'un deuxième matériau M2 gravé ([Fig. 10E]). Elle comprend enfin une sous-étape 1E5-3 de polissage mécano-chimique de sorte à ne conserver la couche de matériau conducteur M4 que dans les motifs gravés ([Fig. 10F]). L'utilisation d'un procédé Damascène permet notamment d'atteindre des densités d'intégration plus importantes. Cependant, si la taille des motifs n'est pas critique, il est possible de faire simplement cette étape en trois temps : un dépôt du matériau, une lithographie et une gravure, comme pour le matériau piézoélectrique M1.

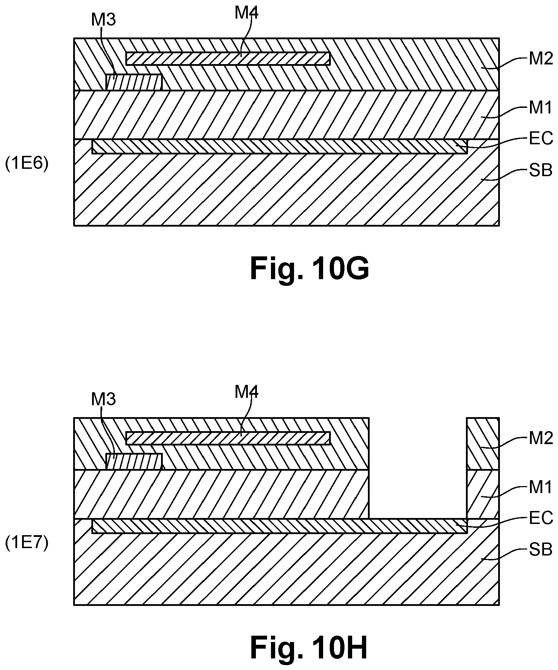

Comme illustré à la [Fig. 10G], le procédé 100 comprend ensuite, une étape 1E6 de dépôt d'une couche du deuxième matériau M2 sur la couche de deuxième matériau M2 déjà présente ainsi que sur le deuxième élément conducteur EC. Cette nouvelle couche a pour but de protéger les couches précédentes et en particulier l'élément conducteur EC (notamment lors de l'étape de gravure).

Dans un mode de réalisation, comme illustré à la [Fig. 10H], lorsque l'étape 1E1 de réalisation d'un premier élément conducteur EC au niveau du substrat SB est mise en oeuvre, le procédé 100 comprend, une étape 1E7 de formation d'une ouverture dans la couche de premier matériau M1 et la couche de deuxième matériau M2 de sorte à exposer le premier élément conducteur EC. Cette ouverture peut par exemple être réalisée à l'aide d'une sous-étape de lithographie permettant de définir le motif associé à l'ouverture suivi d'une sous-étape de gravure anisotrope de la couche de premier matériau M1 et la couche de deuxième matériau M2 selon le motif défini lors de la lithographie.

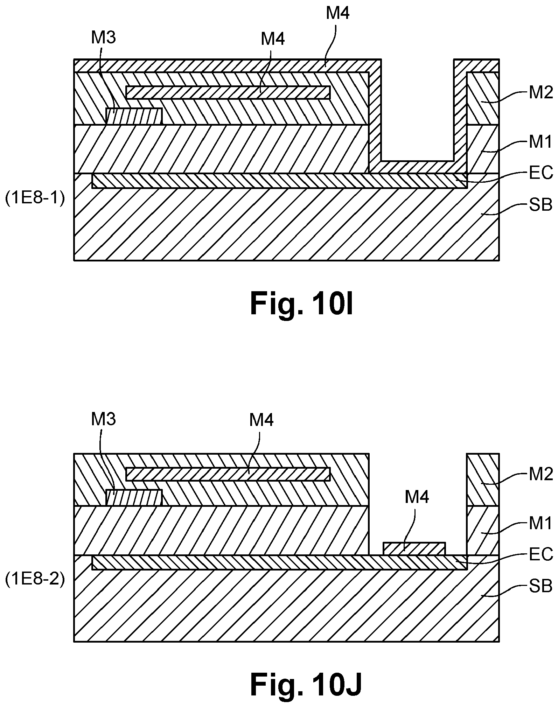

Dans ce mode de réalisation, le procédé 100 comprend également une étape 1E8 de formation d'un contact électrique CT sur le premier élément conducteur EC. Comme illustré à la [Fig. 10I] et à la [Fig 10J], cette étape 1E8 peut être mise en oeuvre à l'aide d'une première sous-étape 1E8-1 de dépôt d'un matériau conducteur, une sous-étape de lithographie de sorte à définir le motif associé au contact électrique CT et une sous-étape 1E8-2 de gravure de la couche de matériau conducteur selon le motif défini lors de la lithographie

Comme illustré à la [Fig. 10K], le procédé 100 comprend une étape 1E9 de gravure isotrope de la couche du premier matériau M1 et de la couche du deuxième matériau M2 de sorte à libérer l'élément mobile EM. La structure finale du procédé 100 selon l'invention lorsque le résonateur optique RO est réalisé par un élément distinct de l'élément mobile EM est illustré à la [Fig. 10L].

### Deuxième procédé

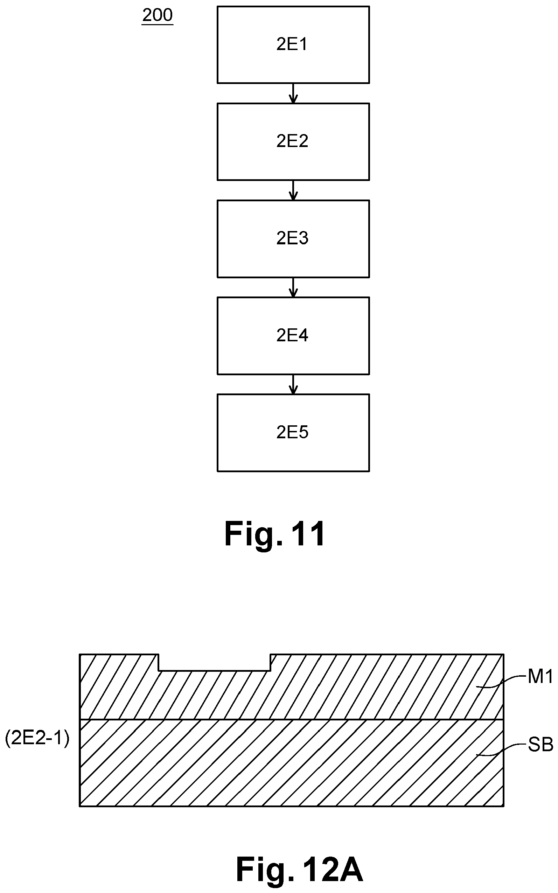

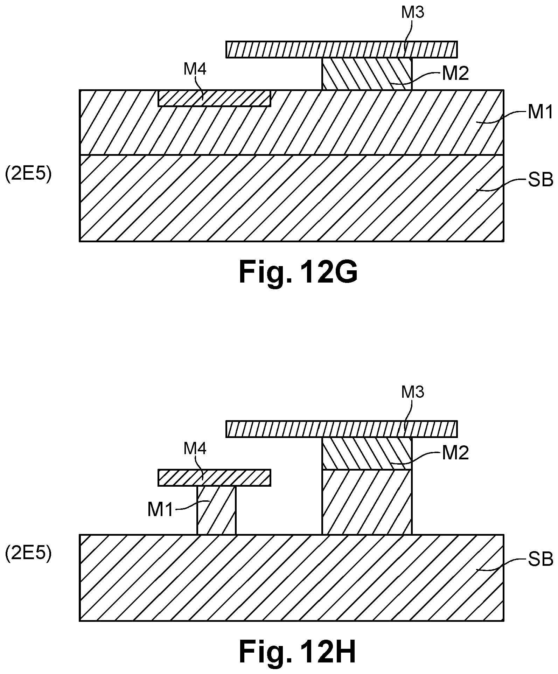

Un troisième aspect de l'invention illustré à la [Fig. 11] et aux [Fig. 12A] à [Fig. 12H] concerne un deuxième procédé 200 de fabrication d'une structure SOM selon l'invention, le procédé en question étant réalisé à partir d'un substrat semi-conducteur SB, de préférence un substrat SB en silicium.

Le procédé comprend une étape 2E1 de dépôt d'une couche d'un premier matériau M1 sur le substrat SB. Dans un mode de réalisation, la couche ainsi déposée a une épaisseur comprise entre 1 µm et 2 µm, de préférence égale à 1.5 µm. Cette couche du premier matériau M1 est destinée à fournir un support structurel à l'élément conducteur EC. De préférence, le premier matériau M1 est choisi de sorte à pouvoir être gravé de manière isotrope afin de pouvoir (dans les étapes suivantes) libérer l'élément conducteur EC. Dans un exemple de réalisation, le premier matériau M1 est de l'oxyde de silicium (SiO₂) ou un alliage d'aluminium, de gallium et d'arsenic (AlGaAs), ces matériaux pouvant par exemple être gravés à l'aide d'acide hydrofluorique (HF).

Le procédé 200 comprend ensuite une étape 2E2 de formation d'un élément conducteur EC (par exemple une électrode ou un résonateur micro-onde) dans la couche de premier matériau M1. Dans un mode de réalisation, l'épaisseur de l'élément conducteur EC est comprise entre 0.4 µm et 1 µm, de préférence égale à 0.5 µm.

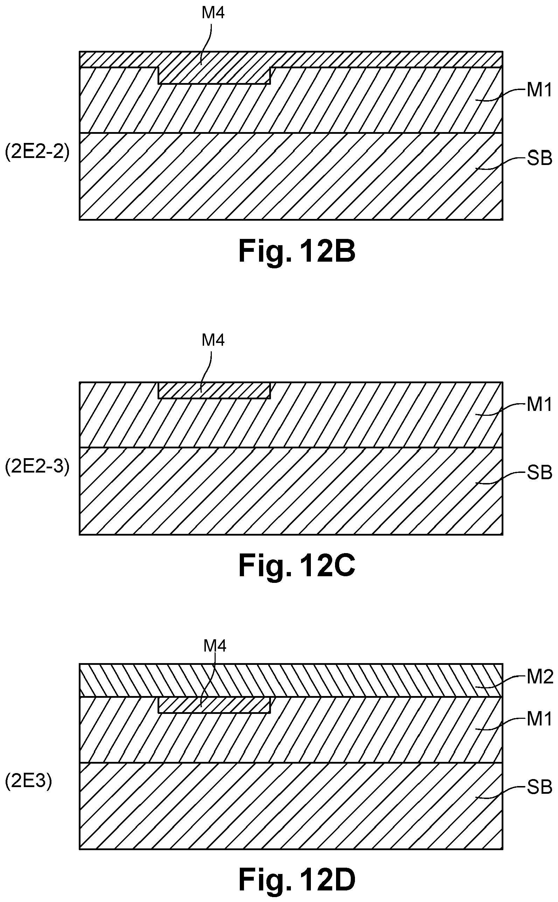

Dans un mode de réalisation illustré aux [Fig. 12A] à [Fig. 12C], l'étape 2E2 de formation d'un élément conducteur EC dans la couche de premier matériau M1 est réalisée à l'aide d'un procédé Damascène bien connue de l'homme du métier. Plus particulièrement, cette étape 2E2 comprend d'abord une sous-étape de lithographie de sorte à définir les motifs de l'électrode. Elle comprend ensuite une sous-étape 2E2-1 de gravure partielle de la couche du premier matériau M1 selon les motifs définis lors de l'étape de lithographie ([Fig. 12A]). Elle comprend ensuite une sous-étape 2E2-2 de dépôt d'une couche d'un matériau conducteur M4 (ce matériau pouvant être supraconducteur) sur la couche d'un premier matériau M1 gravée ([Fig. 12B]). Elle comprend enfin une sous-étape 2E2-3 de polissage mécano-chimique de sorte à ne conserver la couche de matériau conducteur M4 que dans les motifs gravés ([Fig. 12C]). Comme déjà mentionné, l'utilisation d'un procédé Damascène permet notamment d'atteindre des densités d'intégration plus importante.

Comme illustré à la [Fig. 12D], le procédé 200 comprend ensuite une étape 2E3 de dépôt d'une couche d'un deuxième matériau M2 sur la couche de premier matériau M1 et sur l'élément conducteur EC. Dans un mode de réalisation, le deuxième matériau M2 est identique au premier matériau M1. Dans un mode de réalisation, l'épaisseur de la couche de deuxième matériau M2 déposée lors de cette étape 2E3 est comprise entre 0.5 µm et 5 µm, de préférence égale à 1.05 µm.

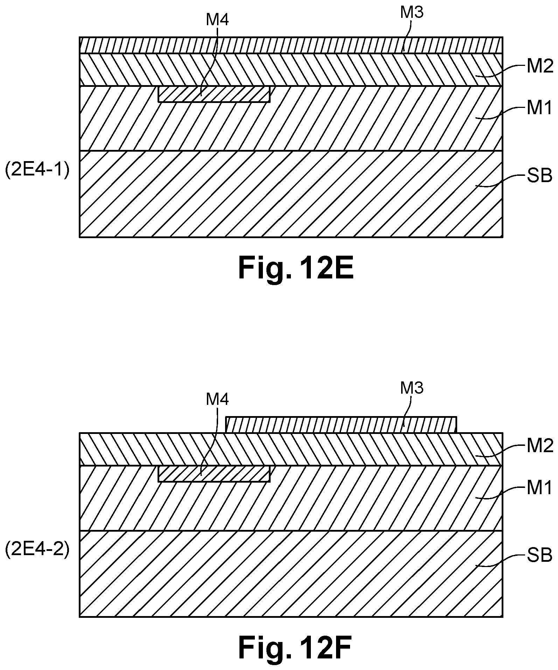

Le procédé 200 comprend ensuite une étape 2E4 de formation d'un élément mobile EM et, éventuellement, d'un résonateur optique RO, dans un matériau piézoélectrique M3. Dans un mode de réalisation illustré aux [Fig. 12E] et [Fig. 12F], cette étape 2E4 comprend tout d'abord une sous-étape 2E4-1 de dépôt, sur la couche du deuxième matériaux M2, d'un matériau piézoélectrique M3 ([Fig. 12E]). Elle comprend également une sous-étape de lithographie de sorte à définir les motifs de l'élément mobile EM et, éventuellement, du résonateur optique RO. Elle comprend enfin une sous-étape 2E4-2 de gravure de la couche de matériau piézoélectrique M3 de sorte à transférer dans ladite couche les motifs de l'élément mobile EM et, éventuellement, du résonateur optique RO, définis lors de la sous-étape de lithographie ([Fig. 12F]).

Comme illustré à la [Fig. 12G], le procédé 200 comprend enfin une étape 2E5 de gravure isotrope de la couche du deuxième matériau M2 de sorte à libérer l'élément mobile EM. Dans un mode de réalisation illustré à la [Fig. 12H], lors de cette étape 2E5, la couche du premier matériau M1 est également gravée de sorte à également libérer l'élément conducteur EC.

## Revendications

1. Structure opto-mécanique (SOM) comportant :
- Un substrat (SB) s'étendant selon un plan (P) ;
- Un élément support (ES) agencé sur le substrat (SB) ;
- Au moins un élément conducteur (EC) adapté pour créer un champ électrique orienté perpendiculairement au plan (P) du substrat (SB) ;
- Un résonateur opto-mécanique comportant :
∘ Un élément mobile mécaniquement (EM) réalisé dans un matériau piézoélectrique et agencé sur l'élément support (ES), le matériau piézoélectrique étant choisi de sorte que le champ électrique créé par l'élément conducteur (EC) lorsque ce dernier est soumis à un potentiel électrique entraîne un déplacement dudit élément mobile (EM) ;
∘ Un résonateur optique (RO) couplé à l'élément mobile (EM) ;
Ledit au moins un élément conducteur (EC) étant situé au-dessus ou au-dessous dudit élément mobile (EM), à une distance non nulle dudit élément mobile (EM), ledit élément conducteur (EC) et ledit élément mobile (EM) ayant au moins une surface en regard l'une de l'autre.

2. Structure opto-mécanique (SOM) selon la revendication précédente dans laquelle l'élément conducteur (EC) est un résonateur micro-onde ou une électrode.

3. Structure opto-mécanique (SOM) selon la revendication 1 comprenant au moins deux éléments conducteurs (EC), un premier élément conducteur (EC) situé au-dessous de l'élément mobile (EM) et un deuxième élément conducteur situé au-dessus de l'élément mobile (EM).

4. Structure opto-mécanique (SOM) selon l'une des revendications précédentes dans laquelle l'élément mobile (EM) et le résonateur optique (RO) sont formés au moyen d'un cristal phoxonique.

5. Structure opto-mécanique (SOM) selon l'une des revendications 1 à 3 dans laquelle le résonateur optique (RO) est un résonateur à mode de galerie, l'élément mobile (EM) étant intégré au résonateur optique (RO).

6. Structure opto-mécanique (SOM) selon l'une des revendications 1 à 3 dans laquelle le résonateur opto-mécanique comprend un guide d'onde (GO) parcourant la périphérie d'une structure centrale (SC), le guide d'onde (GO) étant relié à la structure centrale (SC) par des ancrages (AC), une partie du guide d'onde (GO) formant l'élément mobile (EM).

7. Structure opto-mécanique (SOM) selon la revendication précédente dans laquelle l'élément conducteur (EC) comprend une pluralité d'électrodes, lesdites électrodes étant situées, au moins en partie, en regard de l'élément mobile (EM).

8. Procédé (100) de fabrication d'une structure selon l'une des revendications précédentes comprenant, à partir d'un substrat semi-conducteur (SB) :
- une étape (1E2) de dépôt d'une couche d'un premier matériau (M1) sur le substrat (SB) ;
- une étape (1E3) de formation d'un élément mobile (EM) dans un matériau piézoélectrique (M3) ;
- une étape (1E4) de dépôt d'un deuxième matériau (M2) sur la couche de premier matériau (M1) et sur l'élément mobile (EM) ;
- une étape (1E5) de formation d'un élément conducteur (EC) dans la couche de deuxième matériau (M2) ;
- une étape (1E8) de gravure isotrope de la couche du premier matériau (M1) et de la couche du deuxième matériau (M2) de sorte à libérer l'élément mobile (EM).

9. Procédé (100) selon la revendication précédente dans lequel la structure comporte un premier élément conducteur (EC) et un deuxième élément conducteur (EC), le procédé comprenant, avant étape (1E2) de dépôt d'une couche d'un premier matériau (M1) sur le substrat (SB), une étape (1E1) de réalisation d'un premier élément conducteur (EC) au niveau du substrat (SB), l'élément conducteur (EC) dans la couche de deuxième matériau (M2) formant le deuxième élément conducteur (EC).

10. Procédé (200) de fabrication d'une structure selon l'une des revendications 1 à 7, à partir d'un substrat semi-conducteur (SB) :
- une étape (2E1) de dépôt d'une couche d'un premier matériau (M1) sur le substrat (SB) ;
- une étape (2E2) de formation d'un élément conducteur (EC) dans la couche de premier matériau (M1) ;
- une étape (2E3) de dépôt d'une couche d'un deuxième matériau (M2) sur la couche de premier matériau (M1) et sur l'élément conducteur (EC) ;
- une étape (2E4) de formation d'un élément mobile (EM) dans un matériau piézoélectrique (M3) ;
- une étape (2E5) de gravure isotrope de la couche du deuxième matériau (M2) de sorte à libérer l'élément mobile (EM).

11. Procédé (200) de fabrication selon la revendication précédente dans lequel, lors de l'étape (2E5) de gravure isotrope, la couche du premier matériau (M1) est également gravée de sorte à libérer l'élément conducteur (EC).

12. Procédé (100, 200) selon l'une des revendications 8 à 11 dans lequel le résonateur optique (RO) est réalisé à l'aide d'un élément distinct de l'élément mobile (EM) et l'étape de formation d'un élément mobile (EM) comprend également la formation d'un résonateur optique (RO).
